# EUROPÄISCHE PATENTSCHRIFT

(11) **EP 1 652 281 B1**
(45) Veröffentlichungstag und Bekanntmachung des Hinweises auf die Patenterteilung: **17.01.2007**
(21) Anmeldenummer: 04766332.3
(22) Anmeldetag: 27.07.2004
(51) Int. Cl.: H02H 3/20, B60R 16/02

(54) **VORRICHTUNG ZUM SCHUTZ VON ELEKTRONIK-BAUGRUPPEN IN EINEM MEHRSPANNUNGS-BORDNETZ GEGEN KURZSCHL SSE**
DEVICE FOR THE PROTECTION OF ELECTRONIC MODULES AGAINST SHORT CIRCUITS IN A MULTIVOLTAGE ON-BOARD ELECTRICAL WIRING SYSTEM
DISPOSITIF SERVANT A PROTEGER DES MODULES ELECTRONIQUES DANS UN RESEAU DE BORD MULTITENSION CONTRE DES COURTS-CIRCUITS

(30) Priorität: 28.07.2003 DE 10334399
(43) Veröffentlichungstag der Anmeldung: 03.05.2006
(73) Patentinhaber: SIEMENS AKTIENGESELLSCHAFT, 80333 München (DE)
(72) Erfinder: BOLZ, Stephan, 93102 Pfatter (DE); LUGERT, Günter, 93055 Regensburg (DE)
(86) Internationale Anmeldenummer: PCT/EP2004/051622
(87) Internationale Veröffentlichungsnummer: WO 2005/013453

(56) Entgegenhaltungen:
- EP-A- 0 349 750
- EP-A- 1 453 171
- DE-A1- 19 728 783
- DE-C- 3 425 235

## Beschreibung

Die Erfindung betrifft eine Vorrichtung zum Schutz von Elektronik-Baugruppen, insbesondere von Baugruppen der Steuerelektronik, Datenverarbeitung und -übertragung, von Kleinleistungs-Treiberschaltungen oder CAN-BUS-Transceivern, die üblicherweise an einer Versorgungsspannung Vcc=5V bis 10V betrieben werden und in einem Steuergerät angeordnet sind, also letztendlich von Steuergeräte-Anschlüssen in einem Mehrspannungs-Bordnetz, beispielsweise einem 42V/14V-Kraftfahrzeug-Bordnetz, gegen Kurzschlüsse nach der höchsten in diesem Bordnetz vorkommenden Spannung.

Der ständig wachsende Energiebedarf neuer elektrischer Verbraucher in Kraftfahrzeugen sowie die Notwendigkeit, den Kraftstoffverbrauch beispielsweise durch Unterstützung des Antriebsstranges (Stop-and-go, Boost und rekuperiertes Bremsen) zu reduzieren, sind treibende Kräfte für einen Wechsel vom 14V-Bordnetz zum 42V-Bordnetz.

Um existierende, für ein 14V-Bordnetz entwickelte Elektronik-Baugruppen und Komponenten, zu welchen auch die erwähnten Baugruppen der Steuerelektronik und Datenübertragung zählen, im 42V-Bordnetz betreiben zu können, wurde als Zwischenlösung ein 14V/42V-Zweispannungs-Bordnetz definiert, auf welches die weitere Beschreibung Bezug nimmt.

Das größte Hemmnis bei der Weiterverwendung von für das 14V-Bordnetz - mit der niedrigen Bordnetzspannung - entwickelten Elektronik-Baugruppen und deren Komponenten im 42V-Bordnetz - mit der hohen Bordnetzspannung - ist deren fehlende Kurzschlussfestigkeit beispielsweise nach 50V permanent bzw. 60V transient.

In Kraftfahrzeugen sind die zu den genannten Baugruppen führenden Leitungen in Kabelbäumen verlegt. Kurzschlüsse (Überschläge - Lichtbogen) zwischen diesen Leitungen können beispielsweise durch Aufscheuern entstehen. Die Geschwindigkeit der Spannungsänderung bei einem Kurzschluss von beispielsweise 5V oder 14V nach 42V ist extrem hoch; sie erfolgt innerhalb weniger Nanosekunden!.

Es sind deshalb-Schutzschaltungen erforderlich, die auch später im 42V-Einspannungs-Bordnetz verwendet werden können.

War bisher im 14V-Einspannungs-Bordnetz eine permanente KurzSchlussfestigkeit nach 14V bis 18V, je nach Kundenwunsch, und eine transiente Kurzschlussfestigkeit nach 32V bis 36V ausreichend, so werden im 42V-Bordnetz, wie bereits erwähnt, Spannungsfestigkeiten beispielsweise nach 50V permanent und nach 60V transient gefordert.

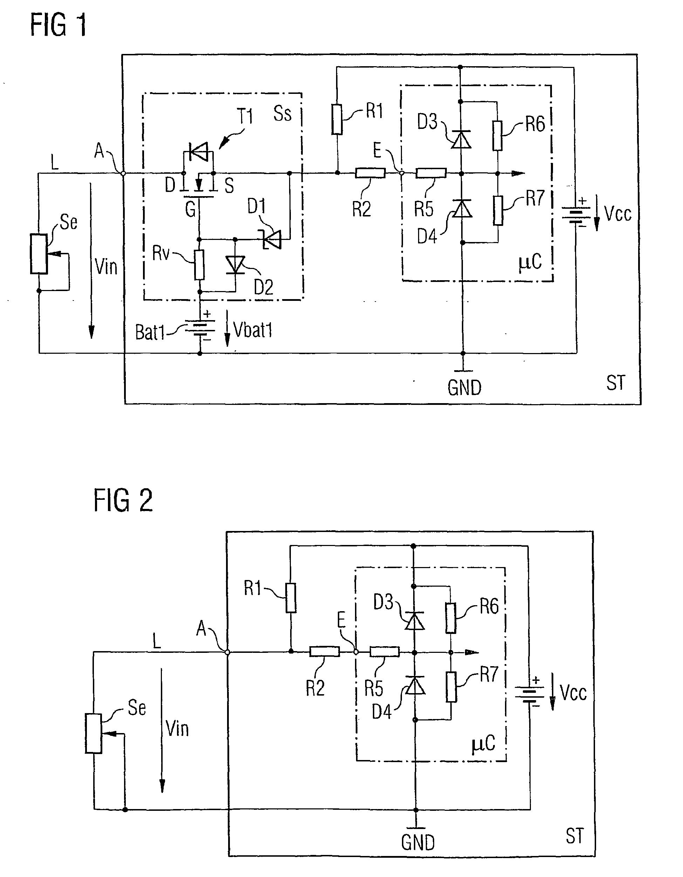

Eine typische Schutzbeschaltung nach dem Stand der Technik in einem 14V-Bordnetz beispielsweise für einen in einem Steuergerät ST angeordneten Mikrocontroller µC ist in Figur 2 dargestellt. Als Eingang E des Mikrocontrollers µC ist beispielhaft der Eingang eines nicht dargestellten Analog-Digital-Converters (ADC) gezeigt, welchem über eine Leitung L das Ausgangssignal eines aus einem veränderlichen Widerstand bestehenden Sensors Se zugeführt wird, welches im durch einen Pfeil angedeuteten Analog-Digital-Converter (ADC) digitalisiert und weiterverarbeitet.

Dem Mikrocontroller µC wird eine stabile Versorgungsspannung Vcc, üblicherweise Vcc=5V, mittels eines im Steuergerät ST vorhandenen, nicht dargestellten Reglers zugeführt.

Dem Eingang E ist eine standardmäßig im Mikrocontroller µC integrierte Schutzstruktur gegen elektrostatische Entladungen zugeordnet, bestehend aus einem dem Eingang E nachgeordneten Widerstand R5, und zwei Dioden D3 und D4, wobei die Diode D3 zwischen dem Widerstand R5 und dem Pluspol +Vcc der Versorgungsspannung Vcc angeordnet ist und in Richtung zum Pluspol +Vcc stromleitend ist, und wobei die Diode D4 zwischen dem Minuspol -Vcc der Versorgungsspannung Vcc (Bezugspotential GND des Steuergeräts ST) und dem Widerstand R5 angeordnet ist und in Richtung zum Widerstand R5 stromleitend ist.

Zwei Widerstände R6 und R7, die parallel zu den Dioden D3 bzw. D4 liegen, stellen parasitäre Leckwiderstände dar. Bedingt durch die im Betrieb auftretenden hohen Temperaturen von >100°C und die Temperaturabhängigkeit der Leckströme in Halbleitern können diese Werte bis ca. 1µA erreichen. Das entspricht einem Leckwiderstand R6, R7 von je ca. 2.5MΩ.

Zwischen dem Sensor S und dem Pluspol +Vcc ist im Steuergerät, aber außerhalb des Mikrocontrollers µC ein Widerstand R1 angeordnet, welcher zusammen mit dem Innenwiderstand Rsens des Sensors S einen Spannungsteiler bildet, welcher mit der Versorgungsspannung Vcc versorgt wird.

Zwischen dem Abgriff dieses Spannungsteilers und dem Eingang E des Mikrocontrollers µC ist ein Schutzwiderstand R2 angeordnet. Am Eingang E des Mikrocontrollers µC liegt, über den Schutzwiderstand R2, die Teilerspannung des Spannungsteilers R1/Rsens. Sie ist ein Maß für den Innenwiderstand des Sensors.

Der Schutzwiderstand R2 ist so zu dimensionieren, dass
- der durch die parasitären Leckwiderstände R6, R7 der Eingangsschutzschaltung verursachte Fehler klein ist, und
- bei externer Maximalspannung im Fehlerfall Vin=Vbat der durch die Diode D3 fließende Strom auf ein akzeptables Maß, beispielsweise <5mA, begrenzt wird. Im 14V-Bordnetz ist es möglich, beide Forderungen zu erfüllen, bei einer Steigerung von 14V auf 42V jedoch nicht mehr:
- wählt man den Schutzwiderstand R2 so groß, dass der durch die Diode D3 fließende Strom im Fehlerfall akzeptabel klein bleibt, so wird der durch die durch die Widerstände R6, R7 fließenden Leckströme verursachte Spannungsfehler inakzeptabel groß;
- lässt man den Wert des Schutzwiderstandes R2 unverändert, so wird der nun (wegen 14V→42V) dreifach erhöhte Strom bei Kurzschluss nach 42V die Eingangsstruktur des Mikrocontrollers µC schädigen oder zerstören.

Diese bekannte Schutzbeschaltung ist also gegen einen Kurzschluss nach 42V nicht geschützt.

Aus DE 197 28 783 A1 ist eine Überspannungsschutzschaltung, insbesondere für Eingänge integrierter Schaltungen bekannt, mit einer Überspannungserkennungsvorrichtung, die beim Auftreten einer Überspannung auf der Eingangsleitung einen mit dieser Eingangsleitung in Reihe liegenden, als MOS-Feldeffekttransistor dargestellten Transistor aktiviert, der dann eine hochohmige Unterbrechung dieser Eingangsleitung bewirkt. Im Normalfall stellt dieser MOS-Feldeffekttransistor (nachfolgend MOSFET genannt) eine niederohmige Leitung in beiden Richtungen dar.

Dieser Transistor liegt mit seiner Drain-Source-Strecke in der zu schützenden Leitung. Zwischen Sourceanschluss und Gateanschluss dieses Transistors liegt eine Zenerdiode, welche die Gate-Source-Spannung auf einen vorgegebenen Wert begrenzt, und zwischen Gateanschluss und dem Pluspol der Bordnetzspannung liegt ein Gatewiderstand.

Diese Schaltung beruht auf dem Prinzip der Erkennung einer Überspannung mit anschließender Abschaltung des Längstransistors. Eine Spannungserkennung ist jedoch prinzipbedingt mit einer Verzögerungszeit behaftet.

Tritt nun eine Überspannung in Form einer schnellen Spannungsänderung auf (z.B. Kurzschluss durch Spannungsüberschlag nach der höheren Bordnetzspannung 42V), so steigt am zu schützenden Knoten die Spannung schlagartig so lange an, bis die Verzögerungszeit plus Ausschaltzeit des Längstransistors abgelaufen ist. Die Geschwindigkeit der Spannungsänderung bei einem Kurzschluß nach 42V ist jedoch, wie bereits ausgeführt, extrem hoch.

Bei solch schnellen Spannungsänderungen erfolgt das Abschalten des Längstransistors - bedingt durch die prinzipbedingten Verzögerungen - erst, nachdem die hohe Spannung bereits am zu schützenden Knoten anliegt. Dies wird auch in der genannten DE 197 28 783 A1 beschrieben, indem "nur noch schmale Schaltspitzen jeweils zu Beginn und Ende jedes der Überspannungsimpulse auftreten" (Spalte 4, Zeilen 62 bis 65).

Aus DE 3425235 C1 ist eine nach dem gleichen Prinzip arbeitende Schaltung bekannt.

Bei schnellen Spannungsänderungen versagen derartige Schaltungen, wie sie in den beiden Dokumenten beschieben sind, prinzipbedingt und sind deshalb für eine Anwendung im Zweispannungs-Bordnetz oder im Einspannungs-Bordnetz mit der höheren Bordnetzspannung ungeeignet.

Der Schaltvorgang kann - je nach Auslegung- zwischen mehreren 100ns und mehreren µs liegen. Eine Zerstörung der zu schützenden Bauteile kann nicht ausgeschlossen werden.

Es ist Aufgabe der Erfindung, eine einfache Vorrichtung zum Schutz von in einem 14V-Bordnetz verwendeten, in einem Steuergerät angeordneten Elektronik-Baugruppen, d.h. also, der Steuergeräte-Ein- und Ausgänge, zu schaffen, so dass diese Baugruppen auch gegen in einem 42V-Bord-netz auftretende Kurzschlüsse sicher geschützt werden können.

Diese Aufgabe wird erfindungsgemäß durch eine Vorrichtung gemäß den Merkmalen von Anspruch 1 gelöst.

Vorteilhafte Weiterbildungen der Erfindung sind den Unteransprüchen zu entnehmen.

Ausführungsbeispiele nach der Erfindung werden nachstehend anhand einer schematischen Zeichnung näher erläutert. In der Zeichnung zeigen:
- Figur 1: die Schaltung einer erfindungsgemäßen Vorrichtung zum Schutz von im 14V-Bordnetz verwendeten Elektronik-Baugruppen gegen Kurzschlüsse in einem 42V-Bordnetz,
- Figur 2: eine bekannte Schutzschaltung für einen Eingang eines Mikrocontrollers in einem 14V-Bordnetz,
- Figur 3: ein Ausführungsbeispiel der erfindungsgemäßen Schutzschaltung für eine Kleinleistungs-Treiberschaltung, und
- Figur 4: ein Ausführungsbeispiel der erfindungsgemäßen Schutzschaltung für einen CAN-Bus-Transceiver.

Die Erfindung verwendet keine Überspannungserkennungsvorrichtung mit anschließender Abschaltung des Längstransistors, sie beruht vielmehr auf dem Prinzip der Strombegrenzung des Längstransistors unter Ausnutzung dessen Abschnürspannung.

Figur 1 zeigt die in einem Steuergerät ST angeordnete Schaltung einer erfindungsgemäßen Schutzschaltung Ss für einen aus Figur 2 bekannten Mikrocontroller µC gegen Kurzschlüsse in einem 42V-Bordnetz, welche zwischen dem Schutzwiderstand R2 und der Leitung L (dem Steuergeräteanschluss A) eingefügt ist. Zusätzlich zu der in Figur 2 dargestellten Schaltung ist in Figur 1 der im 14V/42V-Bordnetz vorhandene 12V-Akkumulator Bat1 des Bordnetzes mit der niedrigen Bordspannung dargestellt, während die Spannungsquelle des Bordnetzes mit der hohen Bordspannung nicht dargestellt ist.

Der in Figur 1 zusätzlich eingezeichnete Spannungspfeil bezeichnet die Spannung Vin eines Sensors Se, welche auch die Kurzschlussspannung nach dem 42V-Bordnetz mit maximal 60V sein kann. Diese Spannung Vin bildet die Eingangsspannung für das Steuergerät ST, deren Wert dem Steuergerät ST über die Leitung L vom Sensor Se übermittelt wird.

Die Schutzschaltung Ss besteht aus einer um einen Transistor T1 aufgebauten Schaltung, wie sie aus DE 197 28 783 A1 bekannt ist. Dieser Transistor T1 ist - bei positiven Eingangsspannungen - vorzugsweise ein N-Kanal-Klein-leistungs-MOSFET (Feld-Effekt-Transistor), dessen Drainanschluss D über den Steuergeräteanschluss A (die Leitung L) mit dem Sensor Se verbunden ist, und dessen Sourceanschluss S mit dem Schutzwiderstand R2 verbunden ist.

Zwischen dem Gateanschluss G des Transistors T1 und dem Pluspol +Vbat1 des 12V-Akkumulators Bat1 ist bekanntermassen der Gatewiderstand Rv angeordnet, und zwischen Gateanschluss G und Sourceanschluss S des Transistors T1 ist eine Zenerdiode als Begrenzerdiode D1 angeordnet, deren Durchbruchspannung Vz so gewählt ist, beispielsweise Vz=18V, dass sie im Normalbetrieb nicht leitet (Vz>Vbat1), aber bereits vor Erreichen der maximal zulässigen Gate-Source-Spannung Vgs des Transistors T1, beispielsweise Vgs=20V, leitet.

Erfindungsgemäß ist dem Gatewiderstand Rv eine Diode D2 parallelgeschaltet, welche in Richtung vom Gateanschluss G zum Pluspol +Vbat1 des Akkumulators Bat1 stromleitend ist.

Diese Diode D2 begrenzt die Gatespannung Vg des Transistors T1 auf einen Wert Vg=Vbat1+Vd, d.h., auf einen Wert der Summe aus der niedrigen Bordnetzspannung Vbat1 plus der Durchlaßspannung Vd der Diode D2.

Bei negativen Eingangsspannungen müsste Transistor T1 ein P-Kanal-MOSFET sein, wobei dann alle Spannungen, auch die Prozessor-Spannungsversorgung, umgedreht werden müssten. Ein MOSFET ist deshalb von Vorteil, weil dieser im Arbeitspunkt keinen Steuerstrom benötigt. Bei Bipolartransistoren, mit welchen die Schaltung prinzipiell ebenfalls funktionieren würde, könnte der Basisstrom die Messfunktion als zusätzlicher Fehlerstrom beeinträchtigen. Im folgenden wird, wenn von Transistor T1 die Rede ist, davon ausgegangen, dass dieser ein N-Kanal-MOSFET ist und die Eingangsspannungen positiv sind.

Im Signalpfad vom Sensor Se zum Eingang E des Mikrocontrollers befindet sich neben dem niederohmigen Schutzwiderstand R2 nur noch der vergleichsweise niedrige Sättigungswiderstand des Transistors T1, beispielsweise 5Ω. Das Sensorsignal wird dabei nur minimal beeinflusst.

Im Normalbetrieb 0V<Vin<Vcc ist Transistor T1 leitend, da dessen über den Gatewiderstand Rv vermittelte Gatespannung bei 14V liegt und die Gate-Source-Spannung Vgs am Transistor T1 wesentlich größer als dessen Thresholdspannung Vth (beispielsweise Vth=3V) ist.

Untersuchung auftretender Fehler:
a) bei einem Kurzschluss nach Bezugspotential GND (Vin=0V) ist die Spannung am Eingang E ebenfalls 0V und die Schutzschaltung Ss arbeitet normal.
b) bei einem am Geräteanschluss A wirkenden Kurzschluss nach 14V (Vbat1) steigt die Sourcespannung Vs des Transistors T1 bis auf einen Wert Vs=Vbat1-Vth, d.h., auf einen Wert Vs<Vbat1, an. Transistor T1 ist nun im Abschnürbereich. Der Strom durch die Diode D3 wird durch den Schutzwiderstand R2 auf einen vorgegebenen, zulässigen Wert begrenzt.
c) bei am Geräteanschluss A wirkenden negativen transienten Spannungen (beispielsweise ISO-Testimpulsen) wird Transistor T1 leitend, wobei seine Gate-Source-Spannung Vgs nun durch die Zenerdiode D1 begrenzt wird. Der Gatewiderstand Rv begrenzt den Stromfluss durch die Zenerdiode D1 auf einen tolerierbaren Wert. Schutzwiderstand R2 begrenzt den Stromfluss durch Diode D4 der Schutzstruktur des Mikrocontrollers µC.
d) bei einem am Geräteanschluss A wirkenden Kurzschluss zum 42V-Bordnetz steigt die Eingangsspannung Vin drastisch an - bis auf maximal 60V. Die Sourcespannung Vs des Transistors T1 wird, wie beim Kurzschluss nach 14V auf einen Wert von Vs=Vbat1-Vth, d.h., auf einen Wert Vs<Vbat1, ansteigen. Da sich Transistor T1 nun im Abschnürbereich befindet, fällt an ihm die gesamte Spannungsdifferenz zur Eingangsspannung Vin ab. Die Drain-Source-Spannung Vds des Transistors T1 wird zu Vds=Vin-(Vbat1-Vth). Die am Transistor T1 entstehende Verlustleistung P(T1) wird dabei durch die Spannungsdifferenz Vds und den Strom I(R2), der durch den Schutzwiderstand R2 fließt, bestimmt: P(T1)=Vds*I(R2). Der bei transienten Spannungen von 60V auftretende Spitzenwert liegt bei <100mW, der Effektivwert bei ca. 60mW, was bei Verwendung eines Standardgehäuses für Transistor T1 gut beherrschbar ist.

Steigt die Eingangsspannung Vin auf Werte >Vbat1, so sinkt die Gate-Source-Spannung Vgs von beispielsweise 14V bis auf die Thresholdspannung Vth, beispielsweise Vth=3V, ab. Dabei müssen die Gate-Kapazitäten des Transistors T1 umgeladen werden. Bei sehr schnellen transienten Spannungen Vin im Kurzschlussfall ist dabei ein kurzfristiger, erhöhter Gatestrom von Ig>10mA erforderlich.

Würde dieser Gatestrom ausschließlich über den Gatewiderstand Rv=10kΩ fließen, so würde dies einen großen Spannungsabfall verursachen. Die Gatespannung würde kurzfristig auf Werte >60V steigen, was einen kurzfristigen, wesentlich erhöhten Stromfluss durch die Diode D3 zur Folge hätte, der diese beschädigen oder zerstören könnte.

Da die zum Gatewiderstand Rv parallel liegende Diode D2 in diesem Fall jedoch in Stromdurchlassrichtung betrieben wird, begrenzt sie die Gatespannung Vg des Transistors T1 auf einen Wert Vbat1+Vd, mit Vd=Durchlassspannung der Diode D2.

Die Schutzschaltung erfüllt somit ihre Funktion sowohl bei einem Fehlerfall im 14V-Bordnetz (niedrige Bordspannung) als auch im 42V-Bordnetz (hohe Bordspannung) bis hin zu schnellen transienten Änderungen der Eingangsspannung Vin.

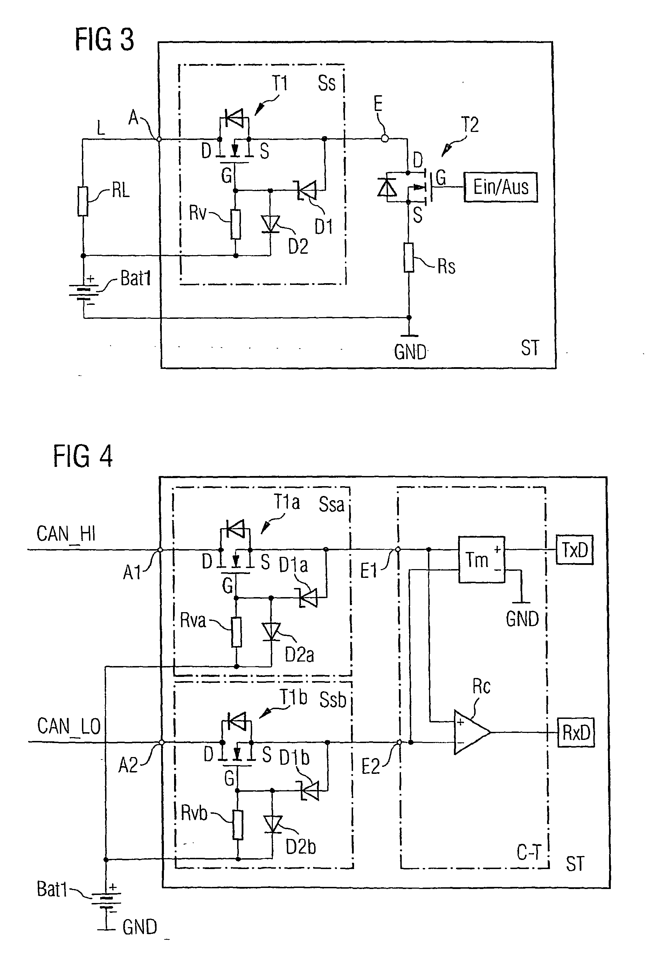

Figur 3 zeigt ein Ausführungsbeispiel der erfindungsgemäßen Schutzschaltung für eine Kleinleistungs-Treiberschaltung. Ein vom 14V-Bordnetz versorgter Verbraucher RL, beispielsweise eine Leuchtdiode einer Warnlampe, wird mittels eines Schalttransistors T2 ein- und ausgeschaltet.

Der Verbraucher RL ist einerseits mit dem Pluspol des Akkumulators Bat1 und andererseits über die Leitung L und den Schalttransistor T2 und einen Schutzwiderstand Rs mit dem Minuspol GND des Akkumulators Bat1 verbunden. Der Schalttransistor T2 kann üblicherweise Teil einer als Mehrfachschalter ausgebildeten Integrierten Schaltung sein.

Ein Kurzschluss nach 42V ohne die erfindungsgemäße Schutzschaltung würde den Schalttransistor T2 zerstören.

Um dies zu verhindern, ist in diese Konfiguration die aus Figur 1 bekannte Schutzschaltung Ss im Steuergerät ST zwischen Transistor T2 und Leitung L so eingefügt, dass der Drainanschluss D des Transistors T1 über Steuergeräteanschluss A und Leitung L mit dem Verbraucher RL und der Sourceanschluss S mit dem Schalttransistor T2 verbunden ist, und dass der Verbindungspunkt von Gatewiderstand Rv und Diode D2 mit dem Pluspol des Akkumulators Bat1 verbunden ist.

Die Funktion der Schutzschaltung ist die gleiche, wie bereits in der Beschreibung von Figur 1 dargestellt.

Figur 4 schließlich zeigt ein Prinzipschaltbild eines im Steuergerät ST angeordneten CAN-Bus-Transceivers C-T mit erfindungsgemäßer Schutzvorrichtung gegen Kurzschlüsse nach 42V. Der Transceiver C-T besteht in an sich bekannter Weise aus einem Transmitter TM (Sendermodul) und einem Receiver RC (Empfängermodul).

Ein geeigneter Transceiver C-T für eine Highspeed-Version ist beispielsweise ein Philips PCA82C250, dessen Daten aus dem Datenblatt "Philips semiconductors PCA82C250 CAN controller interface, Product specification, 13. Januar 2000" entnommen werden können.

Ein High-Speed-CAN-BUS hat üblicherweise zwei differentiell betriebene Leitungen CAN_HI und CAN_LO, deren Spannungen in der Regel 2,5V+1V und 2,5V-1V betragen.

Jede der beiden Bus-Leitungen CAN_HI und CAN_LO ist mit einer eigenen, im Steuergerät ST angeordneten
- Schutzschaltung Ssa: zwischen der Busleitung CAN_HI bzw. Steuergeräteanschluss A1 und Anschluss E1 des Transmitters Tm (Ssa) und
- Schutzschaltung Ssb: zwischen der Busleitung CAN_LO bzw. Steuergeräteanschluss A2 und Anschluss E2 des Receivers Rc ausgerüstet.

Im Normalbetrieb beeinflussen die Schutzschaltungen wegen der geringen Sättigungswiderstände von T1a und Tlb die Funktion von Sender und Empfänger nicht. Erst im Kurzschlussfall gegen 42V wird die Spannung am Transceiver C-T auf einen - zulässigen - Wert von Vbat1-Vth begrenzt.

Die Funktion der Schutzschaltungen Ssa und Ssb ist die gleiche, wie bereits in der Beschreibung von Figur 1 dargestellt.

Die erfindungsgemäße Schutzschaltung ist gegeüber der aus DE 197 28 783 A1 bekannten Schaltung wesentlich einfacher und mit viel weniger Bauelementen aufgebaut.

Sie eignet sich
- zum Schutz von analogen und digitalen Steuergeräteeingängen von Baugruppen der Steuerelektronik und Datenübertragung (Datenschnittstellen), wie beispielsweise auch von Kleinleistungs-Treiberschaltungen oder CAN-BUS-Transceivern, die an einer Versorgungsspannung von beispielsweise Vcc=5V bis 10V betrieben werden und üblicherweise in einem Steuergerät angeordnet sind;
- sie schützt die Anschlüsse (Steuergeräte-Ein- und Ausgänge) zuverlässig auch bei dauerhaftem Anliegen hoher, positiver Überspannungen; selbst schnelle positive Transienten wie Kurzschluss gegen 60V werden nicht durchgelassen und damit sicher beherrscht, negative Transitenten (z.B. ISO-Testpulse) werden toleriert;
- sie ist eigensicher und mit Standardkomponenten kostengünstig und einfach zu implementieren;
- ihr Schaltungskonzept eignet sich zur Integration in ein ASIC, welches auch später im 42V-Einspannungs-Bordnetz verwendet werden kann;
- sie beeinflusst im Normalbetrieb die Genauigkeit der Messwerterfassung nur unwesentlich;
- sie beeinflusst im Normalbetrieb die Funktion der Datenübertragung nicht.

## Patentansprüche

1. Vorrichtung zum Schutz von Elektronik-Baugruppen (µC, C-T, T2), insbesondere von in einem Steuergerät (ST) angeordneten Elektronik-Baugruppen zum Steuern von Kleinleistungsverbrauchern oder zum Verarbeiten/Übertragen von Daten, in einem Mehrspannungs-Bordnetz (12V/42V) mit einem ersten Akkumulator (Bat1) der niedrigen Bordnetzspannung (Vbat1), gegen Kurzschlüsse nach der hohen Bordnetzspannung, mit einem MOSFET-Transistor (T1), dessen Drain-Source-Strecke (D-S) zwischen dem Steuergeräteanschluss (A, A1, A2) und dem Anschluss (E, E1, E2) der Elektronik-Baugruppe (µC, C-T, T2) eingefügt ist, wobei der Sourceanschluss (S) des Transistors (T1) mit dem Anschluss (E, E1, E2) der Elektronik-Baugruppe (µC, C-T, T2) verbunden ist, und deren Drainanschluss (D) mit dem Steuergeräteanschluss (A, A1, A2) verbunden ist, wobei zwischen Gateanschluss (G) und Sourceanschluss (S) des Transistors T1 eine Zenerdiode (D1) angeordnet ist und zwischen dem Gateanschluss (G) des Transistors (T1) und dem Pluspol (+Vbat1) des Akkumulators (Bat1) ein Gatewiderstand (Rv) angeordnet ist,
**dadurch gekennzeichnet,**
**dass** dem Gatewiderstand (Rv) eine Diode (D2) parallelgeschaltet ist, welche in Richtung vom Gateanschluss (G) zum Pluspol (+Vbat1) des Akkumulators (Bat1) stromleitend ist.

2. Vorrichtung nach Anspruch 1, **dadurch gekennzeichnet, dass** die Durchbruchspannung (Vz) der Zenerdiode (D1) niedriger als die maximal zulässige Gate-Source-Spannung (Vgs) des Transistors (T1) gewählt ist.

3. Vorrichtung nach Anspruch 1, **dadurch gekennzeichnet, dass** bei einem am Geräteanschluss (A, A1, A2) wirkenden Kurzschluss nach der höchsten in diesem Bordnetz vorkommenden Spannung die Sourcespannung (Vs) des Transistors (T1) auf einen Wert Vs=Vbat1-Vth der niedrigen Bordspannung (Vbat1), vermindert um die Thresholdspannung (Vth) des Transistors (T1), begrenzt ist.

4. Vorrichtung nach Anspruch 1, **dadurch gekennzeichnet, dass** bei einem am Geräteanschluss (A, A1, A2) wirkenden Kurzschluss nach der höchsten in diesem Bordnetz vorkommenden Spannung die zum Gatewiderstand (Rv) parallel liegende Diode (D2) die Gatespannung (Vg) des Transistors (T1) auf einen Wert Vg=Vbat1+Vd der niedrigen Bordspannung (Vbat1) plus der Durchlassspannung (Vd) der Diode (D2) begrenzt.

5. Vorrichtung nach einem der vorhergehenden Ansprüche, **dadurch gekennzeichnet, dass** die Schutzschaltung (Ss, Ssa, Ssb) in ein ASIC integriert ist.

6. Vorrichtung nach Anspruch 1, **dadurch gekennzeichnet, dass** das Mehrspannungsbordnetz in ein Fahrzeug integriert ist.

## Claims

1. Device for protecting electronic modules (µC, C-T, T2), in particular electronic modules disposed in a control device (ST) for controlling low-power consumers or for processing/transmitting data, in a multi-voltage on-board electrical system (12V/42V) with a first battery (BAT1) of the low on-board electrical system voltage (Vbat1), against short circuits to the high on-board electrical system voltage, with a MOSFET transistor (T1), the drain source path (D-S) of which is inserted between the control device connection (A, A1, A2) and the connection (E, E1, E2) of the electronic module (µC, C-T, T2), with the source connection (S) of the transistor (T1) being connected to the connection (E, E1, E2) of the electronic module (µC, C-T, T2) and its drain connection (D) being connected to the control device connection (A, A1, A2), with a Zener diode (D1) being disposed between the gate connection (G) and the source connection (S) of the transistor (T1) and a gate resistor (Rv) being disposed between the gate connection (G) of the transistor (T1) and the positive pole (+Vbat1) of the battery (Bat1),
**characterised in that**
a diode (D2) is connected parallel to the gate resistor (Rv), conducting current in the direction from the gate connection (G) to the positive pole (+Vbat1) of the battery (Bat1).

2. Device according to claim 1, **characterised in that** the breakdown voltage (Vz) of the Zener diode (D1) is selected to be lower than the maximum permitted gate source voltage (Vgs) of the transistor (T1).

3. Device according to claim 1, **characterised in that** in the event of a short circuit to the highest voltage occurring in the on-board electrical system active at the device connection (A, A1, A2), the source voltage (Vs) of the transistor (T1) is limited to a value Vs = Vbat1 - Vth of the low on-board voltage (Vbat1) minus the threshold voltage (Vth) of the transistor (T1).

4. Device according to claim 1, **characterised in that** in the case of a short circuit to the highest voltage occurring in the on-board electrical system active at the device connection (A, A1, A2), the diode (D2) parallel to the gate resistor (Rv) limits the gate voltage (Vg) of the transistor (T1) to a value Vg = Vbat1 + Vd of the low on-board voltage (Vbat1) plus the conducting state voltage (Vd) of the diode (D2).

5. Device according to one of the preceding claims, **characterised in that** the protective circuit (Ss, Ssa, Ssb) is integrated in an ASIC.

6. Device according to claim 1, **characterised in that** the multi-voltage on-board electrical supply is integrated in a vehicle.

## Revendications

1. Dispositif permettant de protéger des sous-ensembles électroniques (µC, C-T, T2), notamment des sous-ensembles électroniques disposés dans un appareil de commande (ST) et permettant de commander des consommateurs de faible puissance ou de traiter/transmettre des données, dans un réseau de bord à plusieurs tensions (12V/42V) avec un premier accumulateur (Bat1) de la tension de réseau de bord faible (Vbat1), et ce contre des courts-circuits dépassant la tension de réseau de bord élevée, avec un transistor MOSFET (T1) dont la section drain-source (D-S) est insérée entre le raccordement (A, A1, A2) de l'appareil de commande et le raccordement (E, E1, E2) du sous-ensemble électronique (µC, C-T, T2), la borne de source (S) du transistor (T1) étant reliée au raccordement (E, E1, E2) du sous-ensemble électronique (µC, C-T, T2) et la borne de drain (D) de celui-ci étant reliée au raccordement (A, A1, A2) de l'appareil de commande, une diode Zener (D1) étant disposée entre la borne de grille (G) et la borne de source (S) du transistor (T1) et une résistance de grille (Rv) étant disposée entre la borne de grille (G) du transistor (T1) et le pôle positif (+Vbat1) de l'accumulateur (Bat1),
**caractérisé en ce que**
en parallèle avec la résistance de grille (Rv) est montée une diode (D2) qui est conductrice de courant dans le sens allant de la borne de grille (G) au pôle positif (+Vbat1) de l'accumulateur (Bat1).

2. Dispositif selon la revendication 1, **caractérisé en ce que** la tension d'avalanche (Vz) de la diode Zener (D1) est choisie de manière à être inférieure à la tension grille-source (Vgs) maximale autorisée du transistor (T1).

3. Dispositif selon la revendication 1, **caractérisé en ce que**, lors d'un court-circuit agissant au niveau du raccordement (A, A1, A2) de l'appareil et dépassant la tension la plus élevée existant dans ce réseau de bord, la tension de source (Vs) du transistor (T1) est limitée à une valeur Vs=Vbat1-Vth, à savoir à la tension de bord faible (Vbat1), diminuée de la tension de seuil (Vth) du transistor (T1).

4. Dispositif selon la revendication 1, **caractérisé en ce que**, lors d'un court-circuit agissant au niveau du raccordement (A, A1, A2) de l'appareil et dépassant la tension la plus élevée existant dans ce réseau de bord, la diode (D2) montée en parallèle avec la résistance de grille (Rv) limite la tension de grille (Vg) du transistor (T1) à une valeur Vg=Vbat1+Vd, à savoir à la tension de bord faible (Vbat1) augmentée de la tension directe (Vd) de la diode (D2).

5. Dispositif selon l'une des revendications précédentes, **caractérisé en ce que** le circuit de protection (Ss, Ssa, Ssb) est intégré dans un ASIC.

6. Dispositif selon la revendication 1, **caractérisé en ce que** le réseau de bord à plusieurs tensions est intégré dans un véhicule.
